(19) Europäisches Patentamt
European Patent Office
Office européen des brevets

(11) **EP 1 780 556 B1**

(12) **EUROPÄISCHE PATENTSCHRIFT**

(45) Veröffentlichungstag und Bekanntmachung des Hinweises auf die Patenterteilung:
**11.07.2012 Patentblatt 2012/28**

(51) Int Cl.:
***G01R 33/385*** *(2006.01)*

(21) Anmeldenummer: **06022277.5**

(22) Anmeldetag: **25.10.2006**

(54) **Kernspintomographie mit lokalen Magnetfeldgradienten in Verbindung mit lokalen Empfangsspulen**

MRI using local magnetic field gradients and local receiver coils

IRM utilisant des gradients de champ magnétique locaux et des bobines réceptrices locales

(84) Benannte Vertragsstaaten:
**AT CH DE GB LI**

(30) Priorität: **25.10.2005 DE 102005051021**

(43) Veröffentlichungstag der Anmeldung:
**02.05.2007 Patentblatt 2007/18**

(73) Patentinhaber: **Universitätsklinikum Freiburg**
**78106 Freiburg (DE)**

(72) Erfinder: **Hennig, Jürgen, Prof. Dr.**
**79100 Freiburg (DE)**

(74) Vertreter: **Kohler Schmid Möbus**
**Patentanwälte**
**Ruppmannstraße 27**
**70565 Stuttgart (DE)**

(56) Entgegenhaltungen:
**DE-A1- 3 828 718     DE-A1- 19 616 388**
**DE-A1- 19 843 463     GB-A- 2 149 921**
**US-A- 5 530 354     US-A1- 2004 239 325**

• **D.L.LARKMAN ET AL.: "Elimination of Magnetic Field Foldover Artifacts in MR Images" JMRI, Bd. 12, 2000, Seiten 795-797, XP002417684**

**Beschreibung**

Die Erfindung betrifft ein Verfahren der Kernspinresonanztomographie, bei welchem eine, in einem in z-Richtung verlaufenden Hauptmagnetfeld erzeugte, transversale Magnetisierung durch Anwendung von n ≥ 2 zeitlich veränderlichen Magnetfeldern in einem einfach zusammemhängenden abzubildenden Bereich eines Objekts eine n-dimensionale Ortskodierung erfährt.

Ein derartiges Verfahren ist beispielsweise bekannt durch 'Magnetic Resonance Imaging', Ed.MT Vlaardingerbroek, Springer-Verlag.

Bei der Kernspinresonanz-Tomographie werden die Eigenschaften von Atomkernen, insbesondere 1 H-Kernen, zur Bildgebung ausgenutzt. Durch geeignete Hochfrequenzimpulse werden die Kernspins in einer Messprobe, die sich in einem starken statischen Magnetfeld befindet, angeregt und die Hochfrequenzreaktion der Atomkerne wird mit geeigneten Empfangsspulen ausgelesen.

Um ein Messsignal einem Ort in der Messprobe zuordnen zu können werden Kodierverfahren eingesetzt. Dazu werden insbesondere Magnetfelder mit in mindestens einer Richtung über die gesamte Messprobe monoton (und üblicherweise linear) veränderlicher Feldstärke eingesetzt ("konventionelle Gradienten"). Die örtliche Magnetfeldstärke bestimmt die örtliche Larmorfrequenz. Die Zuordnung der Larmorfrequenz zum Ort in der Messprobe ist bei monotonem Kodierfeldverlauf eindeutig. Ortsauflösung und Messzeit hängen von der Gradientenstärke (=Steilheit des Magnetfeldes) ab. Da für eine mehr als ein-dimensionale Ortskodierung mehrere konventionelle Gradienten sukzessive angewendet werden, müssen dies Magnetfelder zudem sehr schnell geschaltet werden. Durch Wechselwirkung mit dem Hauptfeld des Magneten entstehen Lorentzkräfte.

Nachteilig bei diesem Stand der Technik ist zum einen, dass die bei schneller Änderung von monoton verlaufenden konventionellen Gradienten insbesondere bei größeren abzubildenden Bereichen einer Messprobe auftretenden schnellen veränderlichen Lorentzkräfte zu erheblicher mechanischer Beanspruchung führen und die durch diese Kräfte ausgelösten Deformationen zu einer erheblichen Lärmemission von typischerweise 100dBA und mehr führt. Zudem führt die zur Erreichung einer typischen Ortsauflösung und Messzeit erforderliche Gradientenstärke zu sehr großen Magnetfeldunterschieden am Rande des abzubildenden Bereichs. Schnell veränderliche Magnetfeldstärken können zur neuronalen Stimulation bei einem Patienten in medizinischen Anwendungen führen, so dass die Messzeit einer kernspintomographischen Aufnahme mit konventionellen Gradienten letztendlich durch physiologische Faktoren (Lärm, neuronale Stimulation) begrenzt ist.

Neuronale Stimulationen lassen sich durch Verwendung lokaler Gradientensysteme minimieren, bei welchen ein starker Gradient jeweils nur über eine kurze Strecke wirkt, so dass die für die Stimulation relevante lokale Änderung des Feldes dB/dt gering ist. Allerdings treten bei solchen lokalen Gradientensysteme starke mechanische Wechselwirkungen mit dem Hauptfeld auf, die zu sehr starken Vibrationen führen und daher zu einer erhöhten Lärmbelastung führen.

In einem weiteren Verfahren zum Stand der Technik wurde ein in seiner Amplitude entlang mindestens einer Raumrichtung periodisch modulierter Gradient vorgestellt (Oppelt, A, DE 198 43 463 A1), wobei sich daraus ergebende Mehrdeutigkeiten in der Ortskodierung mittels Verfahren der parallelen Bildgebung beseitigt wurden. Durch die Alternierung des Gradienten entlang mindestens einer Raumrichtung wird die für die neuronale Stimulation relevante lokale Feldänderung dB/dt reduziert, wegen der entgegengesetzten Kraftwirkung in alternierenden Gradientenfeldern wird zudem die mechanische Kraftwirkung und damit der Lärm zumindest teilweise reduziert. Ein praktisches Problem dieses Konzeptes ist allerdings durch die Tatsache gegeben, dass eine Alternierung eines Gradienten entlang einer Richtung nur mit einer sehr aufwändige Konstruktion von Magnetfeldspulen realisieren lässt, so dass eine praktische Realisierung eines solchen Gradientensystems erst in jüngster Zeit gelang (Dennis L. Parker, J. Rock Hadley. Gradient Arrays for High Performance Multiple Region MRI. Proc. 14th Meeting ISMRM, Seattle, p.521 (2006). Die Erzeugung eines Gradientenfeldes, welches innerhalb des für die Abbildung verwendeten Zielvolumens unidirektional ist, erfordert auf Grund der mathematischen Struktur der Biot-Savart Gleichungen in der Realisierung mit einem für den Einbau in einen MR-Magneten dimensionierten System endlicher Grösse einen sehr komplexen Stromverlauf.

<u>Aufgabe der Erfindung</u>

Es ist demgegenüber die Aufgabe der vorliegenden Erfindung, ein Magnetfeldresonanz- Tomographie-Verfahren bereitzustellen, das bei gleicher erreichbarer Bildqualität mit geringeren Magnetfeldunterschieden im abzubildenden Bereich auskommt, insbesondere wobei die mechanischen Kräfte auf die Magnetfeldresonanz-Tomographie-Apparatur reduziert sind und schnellere Schaltzeiten für die ortskodierenden Magnetfelder möglich sind. Das Verfahren soll zudem eine einfache Realisierung ermöglichen.

<u>Kurze Beschreibung der Erfindung</u>

Diese Aufgabe wird gelöst durch ein Verfahren gemäß Anspruch 1.

Bevorzugte Verfahrensvarianten sind in den abhängigen Ansprüchen definiert.

Die Grundidee der Erfindung ist es demnach, zur Ortskodierung anstelle eines über den ganzen abzubildenden Bereich bijektiven (d.h. eindeutig zuordenbaren, i. d. R. linearen oder zumindest monoton verlaufenden) und unidirektionalen Magnetfelds ein Magnetfelds einzusetzen, dass nur lokal bijektiv ist und einen gekrümmten Feldverlauf aufweist.

Das Magnetfeld entlang einer Ortsrichtung innerhalb des abzubildenden Bereichs in einem NBSEM non-bijective spatially encoding magnetic field verläuft nicht-monoton, wodurch zum einen die bei monoton veränderlichen Feldern zwangsläufig bedingten Bereiche hoher Feldänderung im Randbereich und die beschriebenen dadurch bedingten Nachteile vermieden werden. Zum andern wirken die in nicht-monotonen Federn auftretenden Lorentzkräfte in unterschiedlichen und zumindest teilweise entgegengesetzter Richtung und sind damit zumindest teilweise selbstkompensierend. Solche nicht-monotonen, nicht-unidirektionalen Magnetfelder führen zu einer nicht-eindeutigen Zuordnung der Larmorfrequenz zum Ort. Die dadurch auftretende Mehrdeutigkeit der Ortszuordnung wird durch eine Zusatzinformation über den Empfangsort eines Signals anhand der zugehörigen Empfangsspule mit lokaler Sensitivität beseitigt. Der abzubildende Bereich wird in mehrere kleinere Teilbereiche zerlegt, in denen parallel Messungen stattfinden. Innerhalb der kleineren Teilbereiche führt die durch die Aufnahmeparameter bestimmte Steilheit des Magnetfeldgradienten für eine Ortskodierung zu relativ geringen Magnetfeldunterschieden.

Verglichen mit unidirektionalen Gradientensystemen gestattet die Erfindung eine sehr viel freiere und insbesondere einfachere Bauweise einer NMR-Tomographieapparatur.

<u>Zeichnung</u>

Die Erfindung ist in der Zeichnung dargestellt und wird anhand von Ausführungsbeispielen näher erläutert. Es zeigt:

Fig. 1A    eine schematische Veranschaulichung des Prinzips der Ortskodierung bei Magnetfeldgradienten nach dem Stand der Technik;

Fig. 1B    eine schematische Veranschaulichung eines ersten Schritts des erfindungsgemäßen Verfahrens der Ortskodierung;

Fig. 1C    eine schematische Veranschaulichung eines zweiten Schritts des erfindungsgemäßen Verfahrens zur Ortskodierung;

Fig. 2A    ein erfindungsgemäßes NBSEM gemäß Patloc Typ 1;

Fig. 2B    ein erfindungsgemäßes NBSEM gemäß Patloc Typ 2;

Fig. 3    eine schematische Veranschaulichung der Abbildungseigenschaften eines nicht-monotonen Magnetfelds;

Fig. 4A    ein erfindungsgemäßes NBSEM mit lokalem Minimum;

Fig. 4B    erfindungsgemäße Sensitivitätsprofile zweier Empfangsspulen im Bereich des NBSEM von Fig. 4A;

Fig. 5    einen schematischen Aufbau einer Apparatur zur Durchführung des erfindungsgemäßen Verfahrens;

Fig. 6    einen Feldverlauf eines erfindungsgemäßen NBSEM;

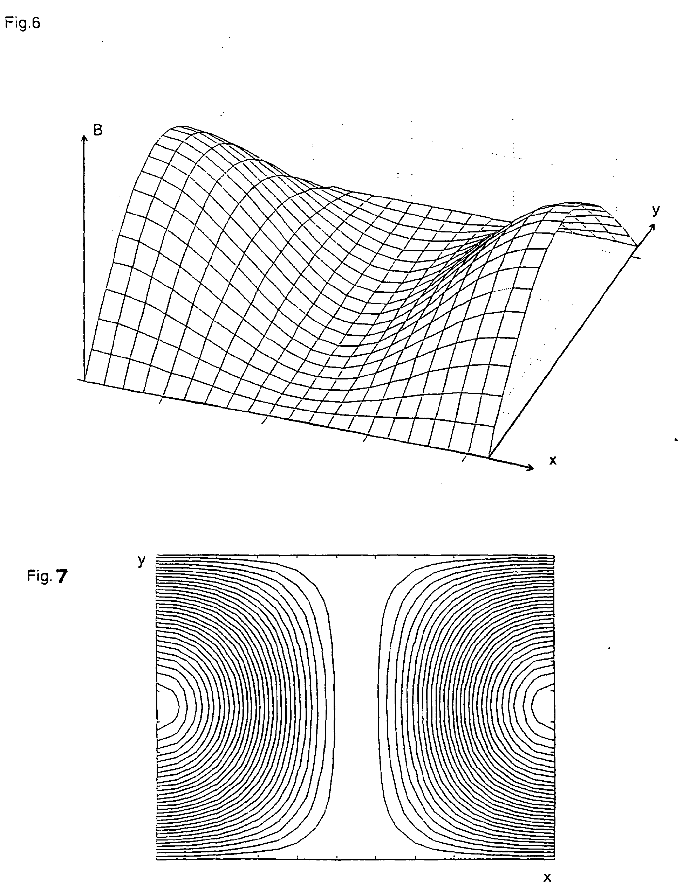

Fig .7    Konturplot des in Fig. 6 dargestellten Feldverlaufs;

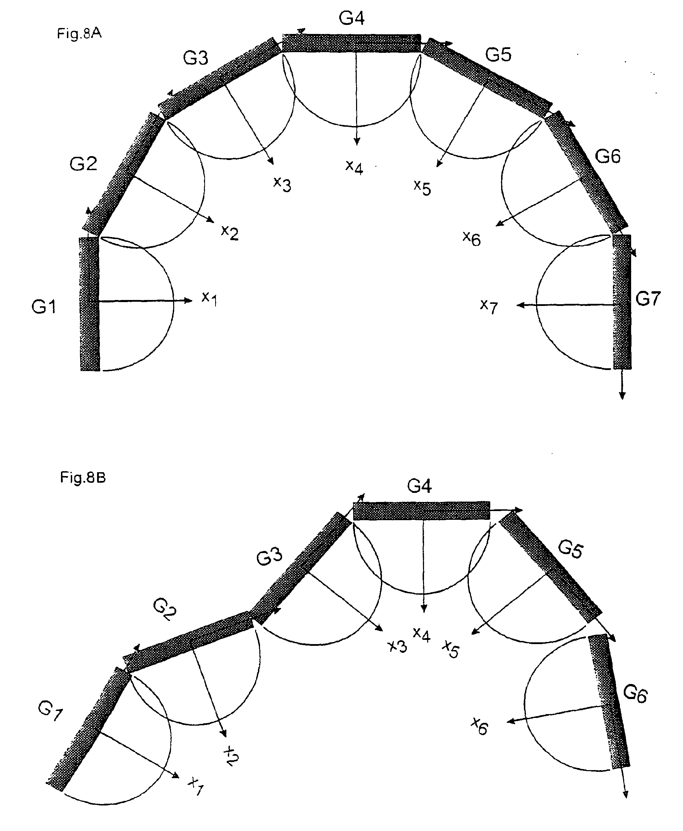

Fig. 8A    eine konvexe Anordnung von Gradientenspulen G1 bis G7 für das erfindungsgemäße Verfahren;

Fig. 8B    eine Anordnung von Gradientenspulen G1 bis G6 in einer anderen Anordnung für das erfindungsgemäße Verfahren;

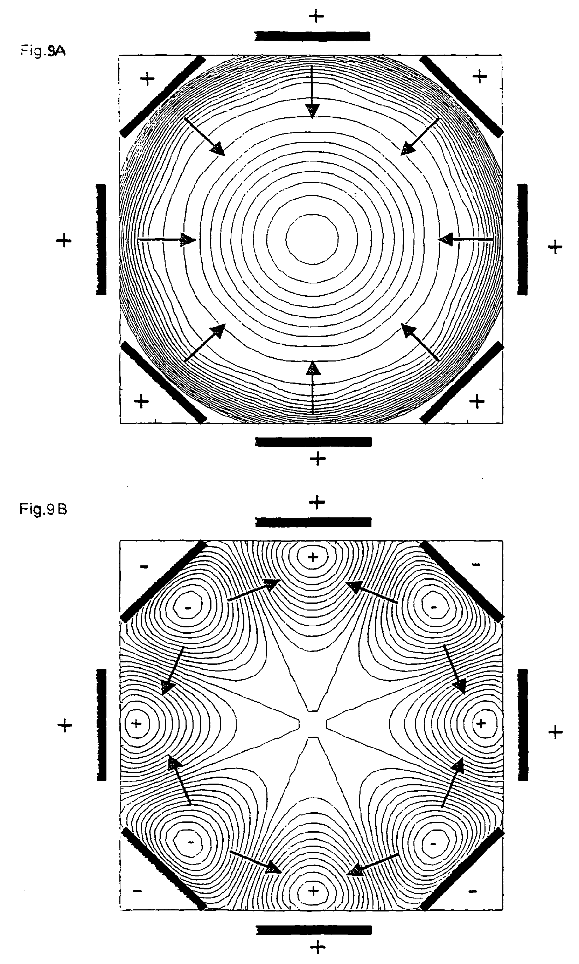

Fig. 9A    eine oktaedrische Anordnung von acht Gradientenspulen, die ein erstes NBSEM für das erfindungsgemäße Verfahren erzeugt;

Fig. 9B    die Anordnung von Fig. 9A, die nunmehr ein zum ersten NBSEM komplementäres, zweites NBSEM erzeugt;

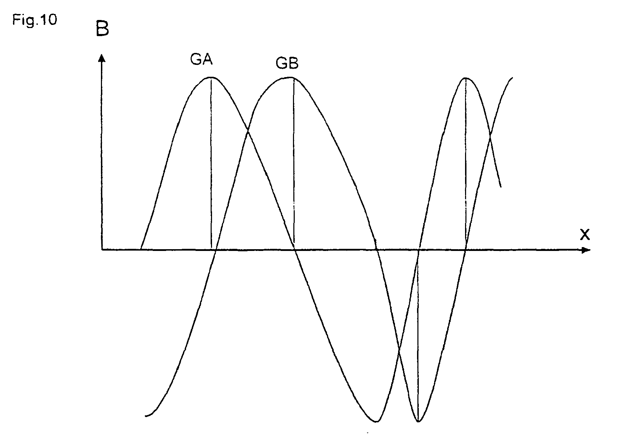

Fig. 10     Grundschema einer erfindungsgemäßen, komplementären Anordnung von NBSEM.

1. Einführung

Die Erfindung betrifft ein Verfahren der MR(= Magnetresonanz)-Tomographie unter Verwendung von zeitlich veränderlichen Magnetfeldgradienten zur Ortskodierung. Bei bisherigen Verfahren der MRT erfolgt die Ortskodierung durch Magnetfeldgradienten, wobei bevorzugt Gradientensysteme mit möglichst räumlich konstantem Magnetfeldgradient entsprechend einer möglichst linearen Änderung der Stärke des Magnetfeldes entlang der jeweiligen Raumrichtung zum Einsatz kommen. Im allgemeinen werden hierbei orthogonale Gradientensysteme mit Gradienten in x-,y- und z-Richtung verwendet. Auch lokale Gradientensysteme sind bekannt und können zur Ortskodierung verwendet werden, wobei hierfür konstruktionsbedingte Abweichungen von einem linearen Verlauf auftreten, welche sich durch entsprechende Verzerrungskorrekturen beseitigen lassen. Auch bei diesen lokalen Gradienten besteht zwar keine lineare, aber immer noch eine monotone und damit eindeutige Beziehung zwischen der lokalen Feldstärke (und damit der Larmorfrequenz) und dem Ort der von den angeregten Spins verursachten Signale. Die eindeutige Zuordnung der Signale erfolgt dann mit einem der bekannten Verfahren durch 1-,2- oder 3-dimensionale Ortskodierung unter Variation der Magnetfeldgradienten in allen drei Raumrichtung entsprechend den bekannten Prinzipien etwa der Fourierkodierung, der gefilterten Rückprojektion oder einem anderen der bekannten Verfahren, gegebenenfalls in Verbindung mit schichtselektiven Pulsen in einer, zwei oder drei Raumrichtungen zur Einschränkung des Messvolumens. Allen diesen Verfahren gemeinsam ist die Tatsache, dass nach Ablauf der bildgebenden Messsequenz eine eindeutige Zuordnung der gemessenen Signale zum Ort besteht.

Das gemeinsame Grundprinzip aller durch räumlich veränderliche Magnetfelder definierten Abbildungsverfahren beinhaltet dabei, dass zur Kodierung einer nddimensionalen Abbildung (nd=1,2,3) nd räumlich veränderliche Magnetfelder angewendet werden, welche im allgemeinen einen zumindest annähernd linearen Verlauf (=räumlich konstanter Gradient) aufweisen und senkrecht aufeinander stehen. Die Dimensionalität der Ortskodierung von inhärent dreidimensionalen Objekten lässt sich unter Anwendung von Schichtselektionsverfahren auf zwei-dimensionale Verfahren (Bildgebung), ein-dimensinale Verfahren (linescan) oder auch direkte Voxelselektion reduzieren, wobei das am häufigsten verwendete Verfahren aus einer 2-dimensionalen Abbildung (=Bildgebung) besteht.

Hierbei werden räumlich veränderliche Magnetfelder $B_z(x,y,z)$ zur Ortskodierung eingesetzt, welche eine lokale Änderung des Hauptfeldes $B_{z0}$ bewirken und dazu führen, dass Kerne an unterschiedlichen Orten unterschiedliche Larmorfrequenzen aufweisen. Diese Felder werden idealer weise als entlang den 3 Raumrichtungen linear veränderliche Felder angewendet, welche im Sprachgebrauch als die x-,y- und z-Gradienten $G_x$, $G_y$ und $G_z$ bezeichnet werden. Für konstante Gradienten der Stärk $g_x$, gy und $g_z$ entsprechend einer linearen Änderung des Magnetfelds entlang der jeweiligen Ortskoordinate gilt:

$$G_x = B_z(x,0,0) = x\, g_x \ , \ G_y = B_z(0,y,0) = y\, g_y \ \text{und} \ G_z = B_z(0,0,z) = z\, g_z. \quad (1)$$

Auf Grund dieser Ausprägung der räumlich veränderlichen Magnetfelder als Felder mit linear entlang dem Ort ändernder Feldstärke hat sich ergeben, dass im Sprachgebrauch die zur Ortskodierung verwendeten Felder (oder auch die zur Erzeugung dieser Felder verwendeten Vorrichtungen) ganz allgemein als ‚Gradienten' bezeichnet werden. Der Begriff des Gradienten impliziert zum einen eine monotone Steigung (wie sie bei konventionellen Gradienten auch vorliegt) zum andern auch eine unidirektionale Ausrichtung. Zur Bezeichnung auch nicht-monotoner, nicht-unidirektionaler räumlich veränderlicher Magnetfelder wird im folgenden der Begriff SEM (=spatial encoding magnetic field) als Oberbegriff eingeführt. Zur Klärung des Sprachgebrauchs im folgenden eine Definition der verwendeten Begriffe:

Gradient: Räumlich veränderliches Magnetfeld im allgemeinen gebraucht im Sinne eines -> konventionellen Gradienten.

konventioneller Gradient: Räumlich veränderliches Magnetfeld mit annähernd linearem und unidirektionalem Feldverlauf entlang der jeweiligen Ortsrichtung - > MSEM.

Gradientensystem: Gesamtheit einer zur Ortskodierung verwendeten Vorrichtung. Ein Gradientensystem erzeugt im Stand der Technik üblicherweise 3 konventionelle Gradienten in x-, y- und z-Richtung, wohingegen in der erfindungsgemässen Anordnung wenigstens eines der zur Ortskodierung verwendeten Felder als NBSEM ausgeführt ist.

SEM (spatially encoding magnetic field) : ein räumlich und zeitlich veränderliches Magnetfeld, welches zur Ortkodierung verwendet wird und welches entweder als konventioneller Gradient (= MSEM entsprechend einem monoton veränderlichen Feld) ausgeführt sein kann oder als NBSEM (= non-bijective spatially encoding field).

MSEM (montonic spatially encoding magnetic field): monoton veränderliches Magnetfeld zur Ortskodierung -> konventioneller Gradient.

NBSEM (non-bijective spatially encoding field): ein räumlich und zeitlich veränderliches Magnetfeld, welches zur Ortkodierung verwendet wird und welches so gestaltet ist, das die Zuordnung der lokalen Feldstärke zum Ort entlang wenigstens eines Ortsvektors nicht-bijektiv ist. Bijektivität wird insbesondere erreicht durch nicht-monotonen Verlauf eines in jedem Teilbereich unidirektionalen aber insgesamt nicht unidirektionalen Gradientenfeldes (in der Beschreibung Patloc Typ1) oder durch ein in mindestens einem Teilbereich nicht unidirektionales Gradientenfeld entsprechend einem gekrümmten Verlauf des Feldes (Patloc Typ 2).

Mathematisch betrachtet besteht das Prinzip der Ortskodierung über räumlich veränderliche Magnetfeldgradienten darin, der zu bestimmenden Signalintensität Ir(x,y,z) im Ortsraum über die Verwendung von Magnetfeldgradienten jeweils eine Signalintensität $I_\omega(\omega_{kx},\omega_{ky},\omega_{kz})$ im Frequenzraum zuzuordnen. $I_\omega(\omega_{kx},\omega_{ky},\omega_{kz})$ ergibt sich dabei aus der Fouriertransformation der aufgenommenen k-Raumdaten $F(k_x,ky,k_z)$.

Allgemein gilt für eine N-dimensionale Abbildung unter Verwendung von N unterschiedlichen Magnetfeldprofile Bz(x,y,z):

$$I\omega(\omega_{kx},\ \omega_{ky},\ \omega_{kz}) = FT\left\{\ \iiint M(x,y,z)\ exp\left(-i\gamma \int Bz(x,y,z,t)\ dt\ \right)dxdydz\right\} \qquad (2)$$

wobei M(x,y,z) die Magnetisierung am Ort (x,y,z) darstellt. Für konventionelle Bildgebung werden konstante Magnetfeldgradienten in den 3 Raumrichtungen verwendet (s. Gleichung (1)).

Bei n-dimensionaler Datenaufnahme ergibt sich eine Abbildung im Frequenzraum $I_\omega(\omega_{kx},\omega_{ky},\omega_{kz})$, welche sich durch lineare Transformation direkt in Ir(x,y,z) überführen lässt. Auch bei nicht-konstanten (aber monoton verlaufenden) Gradienten lässt sich $I_\omega(\omega_{kx},\omega_{ky},\omega_{kz})$ durch nicht-lineare (aber eindeutige) Transformation nach Ir(x,y,z) transformieren:

Aus der Larmorbeziehung

$$f(x,y,z) = (\omega_{kx},\ \omega_{ky},\ \omega_{kz}) = \gamma\ G(x,y,z)$$

folgt

$$f^{-1}(\omega_{kx},\ \omega_{ky},\ \omega_{kz}) = (x,\ y,\ z) = 1/\gamma\ G^{-1}(x,y,z) \qquad (3),$$

d.h. die Abbildung von $(\omega_{kx},\ \omega_{ky},\ \omega_{kz})$ nach (x, y, z) ergibt sich über die Umkehrfunktion des Gradientenverlaufs.

Bei Ortskodierung mit konventionellen Gradienten ergibt sich damit eine lineare Beziehung zwischen $(\omega_{kx},\ \omega_{ky},\ \omega_{kz})$ und (x, y, z) entsprechend

$$(x,\ y,\ z) = (\omega_{kx},\ \omega_{ky},\ \omega_{kz})/(\gamma * G(x,y,z)) \qquad (4),$$

die sich bei unidirektionalen Gradienten separieren lässt in

$$(x) = (\omega_{kx})/(\gamma * G(x)) \qquad (4a),$$

$$(y) = (\omega_{ky})/(\gamma * G(y)) \hspace{4cm} (4b),$$

$$(z) = (\omega_{kz})/(\gamma * G(z)) \hspace{4cm} (4c)$$

oder in vektorieller Schreibweise:

$$\begin{pmatrix} x \\ y \\ z \end{pmatrix} = 1/\gamma \begin{pmatrix} \omega_{kx} & 0 & 0 \\ 0 & \omega_{ky} & 0 \\ 0 & 0 & \omega_{kz} \end{pmatrix} \begin{pmatrix} G(x) \\ G(y) \\ G(z) \end{pmatrix} \hspace{2cm} (5)$$

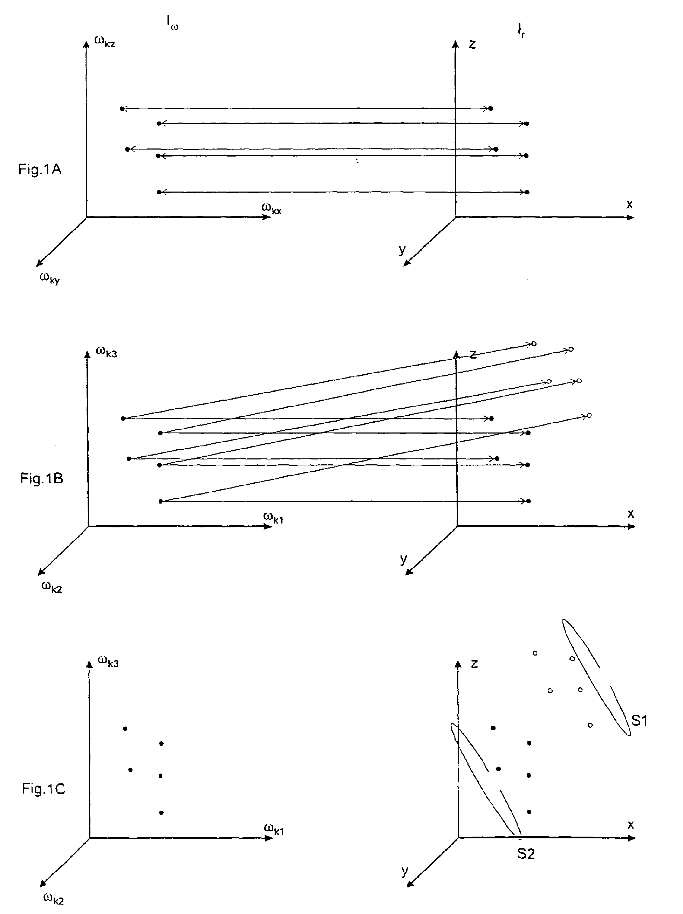

Die Kolinearität der Basisfunktionen (x,y,z) bzw. ($\omega_{kx}$, $\omega_{ky}$, $\omega_{kz}$) zu den Frequenzkoordinaten und ihre inhärente Orthogonalität des durch die jeweiligen Vektoren aufgespannten Raumes ist Basis des k-Raum Konzeptes, welches die ein-ein-deutige Äquivalenz zwischen Orts- und Frequenzraum wiedergibt. Die Abbildung ist immer dann eindeutig, wenn der Gradientenverlauf streng monoton und damit bijektiv ist, da dann und nur dann jedem Punkt im Ortsraum (x, y,z) ein Punkt im Frequenzraum ($\omega_{kx}$, $\omega_{ky}$, $\omega_{kz}$) in ein-eindeutiger Weise zugeordnet ist, d.h. die Umkehrfunktion des Feldverlaufs ist eindeutig (s. Fig.1A).

Für nichtlineare Felder ergibt sich eine nichtlineare Abbildungsgleichung bei welcher im allgemeinen Fall die Zuordnung der Ortskoordinaten zu einem Ort durch einen an jedem Ort unterschiedlichen Tensor erfolgt:

$$\begin{pmatrix} x \\ y \\ z \end{pmatrix} = 1/\gamma \begin{pmatrix} \omega_{kx} & \omega_{kxy} & \omega_{kxz} \\ \omega_{kyx} & \omega_{ky} & \omega_{kyz} \\ \omega_{kzx} & \omega_{kzy} & \omega_{kzz} \end{pmatrix} \begin{pmatrix} G(x) \\ G(y) \\ G(z) \end{pmatrix} \hspace{2cm} (6)$$

Die Vektoren in Ortsraum und Frequenzraum sind nicht mehr kolinear, eine direkte Zuordnung zwischen den Vektoren im Orts- und Frequenzraum ist nicht mehr gegeben.

Für zwei- und ein-dimensionale Datenaufnahme lassen sich Gleichungen (1)-(4) natürlich entsprechend umformen, wobei eine entsprechende Reduktion des Beobachtungsvolumens auf eine Schicht oder ein Voxel durch entsprechende Schichtselektionspulse erfolgen kann oder alternativ die Aufnahme als Projektsverfahren durchgeführt wird, bei welcher die Signale entlang der nicht ortskodierten Richtung auf jeweils einen Bildpunkt projiziert werden.

2. Erfindungsgemäße Ortskodierung

Das erfindungsgemäße Verfahren verwendet demgegenüber zur Ortskodierung räumlich und zeitlich veränderliche Magnetfelder, die dadurch gekennzeichnet sind, dass die durch diese Felder bewirkte Ortskodierung im Frequenzraum $I_\omega$($\omega_{k1}$, $\omega_{k2}$, $\omega_{k3}$...) in Bezug auf den Ortsraum Ir(x,y,z) des zu untersuchenden Messvolumen des untersuchten Objekts nicht bijektiv und entsprechend Gl.(6) nicht kolinear ist, so dass eine Durchführung der Datenaufnahme unter Verwendung solcher Felder zu einer Mehrdeutigkeit der Abbildung führt wie in Fig.1B dargestellt. Bei der Datenaufnahme nach irgend einem auf der Verwendung ortskodierender SEM beruhenden Messverfahren zur zwei-oder dreidimensionalen Bildgebung wird daher rein formal mindestens einer der bei konventioneller Datenaufnahme verwendeten MSEM (= konventioneller Gradient) entlang einer Raumrichtung durch ein solches zu einer nicht-eindeutigen Ortskodierung führendes räumlich veränderliches Magnetfeld ersetzt.

Eine hierfür hinreichende Konfiguration besteht darin, dass mindestens eines der zur Ortskodierung verwendeten räumlich und zeitlich veränderlichen ortskodierenden Magnetfelder einen nicht-monotonen und gekrümmten Verlauf hat, d.h. das durch dieses Ortskodierfeld erzeugte Magnetfeld weist im abzubildenden Bereich des abzubildenden Objektes lokale Minima (und/oder Maxima) auf. Die Verwendung eines solchen nicht-bijektiven NBSEM führt zu einer zwei- (oder mehr-)fachen Mehrdeutigkeit der Zuordnung der Ortsfrequenzen. Bei Verwendung von räumlich variablen Magnetfeldern, bei welchen mindestens eines der verwendeten räumlich variablen Magnetfelder lokale Extremwerte aufweist, erlaubt die Abbildung entsprechend Gl.(1) keine eindeutige Zuordnung von $I_\omega$($\omega_{kx}$, $\omega_{ky}$, $\omega_{kz}$) nach Ir(x,y,z), sondern es ergeben sich Mehrdeutigkeiten in der Abbildung, d.h. zumindest in einem Teilbereich des Bildes existieren paarweise Orte, deren Koordinaten x1, y1, z1 und x2, y2, z2 identischen Koordinaten im Frequenzraum entsprechen.

Analog zu den unidirektionalen alternierenden Feldern (Oppelt) werden für die Datenaufnahme in solchen nicht-bijektiven und gekrümmten ortskodierenden Magnetfeldern mehrere (mindestens 2) Spulen mit räumlich veränderlichem und unterschiedlichen Empfindlichkeitsprofil verwendet und zwar so, dass unter Berücksichtigung der räumlichen Empfindlichkeiten der Spulen eine eindeutige Ortskodierung erfolgt (Fig.1C).

Das erfindungsgemäße Verfahren beruht dabei auf der Erkenntnis, dass sich die Mehrdeutigkeiten in Bezug auf die Ortskodierung durch NBSEM durch Unterteilung des gesamten Messbereichs entlang der durch lokale Extremwerte (Minima oder Maxima) definierten Hyperflächen in ng Teilbereiche oder Regionen unterteilen lassen, innerhalb derer eine eindeutige (aber nicht kolineare) Zuordnung zwischen $I_\omega(\omega_{kx}, \omega_{ky}, \omega_{kz})$ und Ir(x,y,z) besteht. Verwendet man nun zur Datenaufnahme mindestens ng Empfangsspulen mit jeweils räumlich variablem und voneinander unterschiedlichen Sensibilitätsprofilen, wobei die Zahl ng der Messspulen mindestens so groß sein muss wie die Mehrdeutigkeit der Zuordnung, so lassen sich die gemessenen Signale eindeutig zuordnen. Ein so gestaltetes erfindungsgemäßes System unter Verwendung von nicht bijektiven gekrümmten NBSEM in Kombination mit Empfangsspulen mit räumlich selektivem Empfindlichkeitsprofil wird im folgenden als PatLoc-System (= parallel imaging with local gradients) genannt.

Dieses Grundprinzip ist im folgenden veranschaulicht.

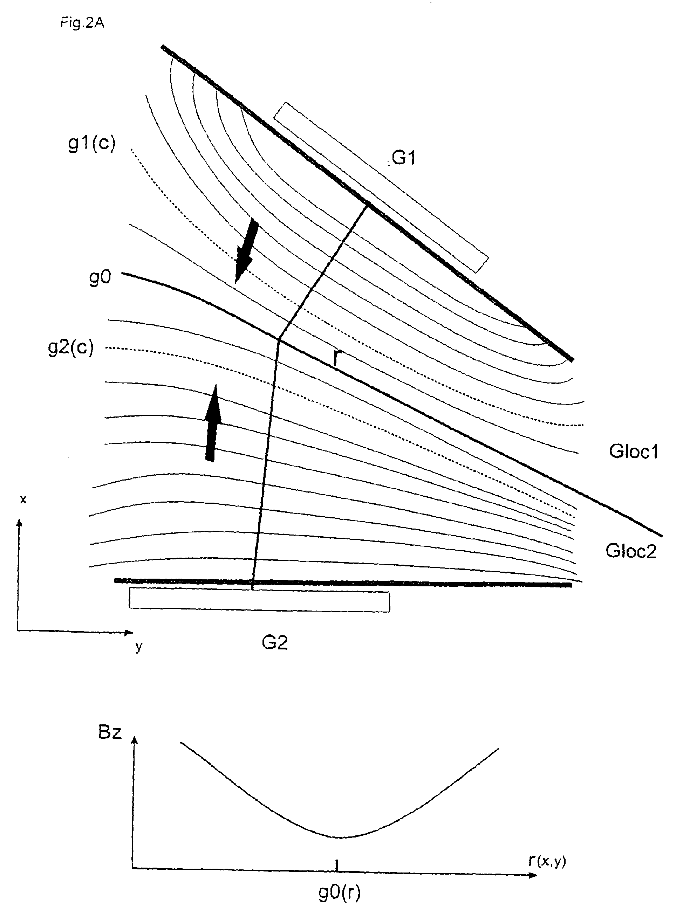

Dabei zeigt Fig.2A anschaulich ein NBSEM mit dem gezeigten (2-dimensionalen) Feldverlauf, welcher sich dadurch auszeichnet, dass die Funktion der Feldstärke entlang einer (im Prinzip beliebigen) Ortsrichtung r einen Extremwert (Maximum oder Minimum, im Beispiel ein Minimum) durchläuft. Beiderseits der durch g0 gekennzeichneten gekrümmten Verbindungslinie der Extremwerte existieren jeweils Orte gleichen Feldes, wie beispielhaft anhand der Höhenlinien g1 (c) und g2(c) gezeigt. Ein derartiges Magnetfeldprofil lässt sich entlang g0 in zwei als Gloc1 und Gloc2 gekennzeichnete Bereiche unterteilen. Innerhalb jedes dieser Bereiche ist der Feldverlauf monoton und damit zur Ortskodierung mit einer eindeutigen Abbildung geeignet.

Allgemein ist eine Hyperfläche definiert als ein (n-1) dimensionale Entität einer n-dimensionalen Funktion. Bei einer zweidimensionalen Abbildung ist die zur Trennung in lokal eindeutige Bereiche verwendete ‚Hyperfläche' daher - wie gezeigt - eine Linie, im dreidimensionalen Fall eine im allgemeinen im Raum gekrümmte Fläche. Ein solches Feldprofil, welches durch entsprechende Hyperflächen in eindeutig zuordenbare Teilbereiche erfolgt, wird im folgenden als Patloc Typ1 bezeichnet.

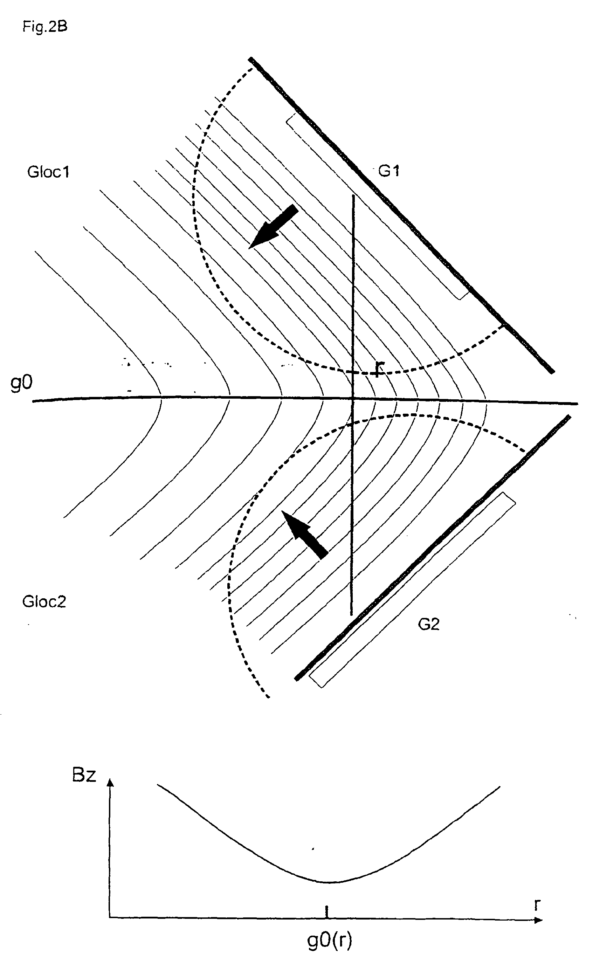

Eine weitere Ausgestaltung des Magnetfeldes, die nach dem selben Prinzip in Bereiche mit eindeutiger Feldzuordnung zerlegt werden kann, so dass eine eindeutige Zuordnung durch Messung mit separaten Empfangsspulen für Signale aus den jeweils lokal eindeutigen Feldbereichen erfolgt, ist in Fig.2B gezeigt. Hierbei ist das Feldprofil so gestaltet, dass das Feld zwischen den Empfangsbereichen so stark gekrümmt ist, dass sich wiederum entlang mindestens einer Ortsrichtung r(z) ein Feldverlauf mit einem lokalen Minimum ergibt, wobei z hier eine beliebige Richtung im Raum kennzeichnet. Das dreidimensionale Magnetfeld hat hierbei nicht notwendigerweise ein Minimum/Maximum, ein solches tritt lediglich entlang einer (beliebigen) Richtung auf. Eine solche Anordnung soll im folgenden als Patloc Typ2 bezeichnet werden.

Als notwendige und hinreichende Bedingung des erfindungsgemäßen Verfahrens ist aus diesen Beispielen abzuleiten, dass das (im allgemeinen dreidimensionale) zur Ortskodierung verwendete Magnetfeldprofil so gestaltet ist, dass es entlang eines gekrümmten Ortsvektors lokale Extremwerte aufweist. Hierbei soll darauf hingewiesen werden, dass natürlich auch konventionelle lineare Felder zwangsläufig durch ihre endliche Ausdehnung im jeweiligen Abfallbereich an den Rändern solche Extremwerte aufweisen. Bei konventionellen Aufnahmeverfahren wird die Datenaufnahme jedoch so durchgeführt, dass diese Randbereiche von der Aufnahme ausgeschlossen werden, bzw. durch entsprechende Verfahren die durch unbeabsichtigte Einfaltungen entstehenden Bildartefakte beseitigt werden. Vorrichtungen und Verfahren, bei welchen eine solche mehrdeutige Abbildung als integraler Teil der Ortskodierung realisiert werden, sind bisher nicht bekannt.

Zur Vereinfachung erfolgt die Diskussion im folgenden anhand eines eindimensionalen Verlaufs eines NBSEM entsprechend Patloc Typ 1. Im ein-dimensionalen Fall entsprechen die Grundzüge des Abbildungsverhaltens prinzipiell den für den unidirektionalen Feldverlauf von Oppelt gezeigten Rahmenbedingungen, allerdings mit der Nebenbedingungen, dass die Ortsvektoren entlang des Profils der NBSEM nunmehr im Raum gekrümmt sind.

Die räumliche Auflösung entlang dieser gekrümmten Ortsvektoren bei der Verwendung von NBSEM hängt von der (lokalen) Steilheit des Magnetfeldgradienten ab. Allgemein gilt, dass die Größe des Aufnahmefensters $\Delta\omega$ im Frequenzraum $I_\omega$ bei diskreter Datenaufnahme unter Aufnahme eines komplexen Datenpunktes im zeitlichen Abstand $t_s$ entsprechend dem Nyquist-theorem gegeben ist durch

$$\Delta\omega = 1/ts. \qquad (7)$$

Bei Datenaufnahme von mr Datenpunkten in einer Aufnahmezeit $t_{ACQ}$= mr $t_s$ ergibt sich die Auflösung (Pixelgröße) $\omega_{res}$ im Frequenzraum entsprechend dem Sampling Theorem zu

$$\omega_{res} = \Delta\omega/mr. \qquad (8)$$

Bei der konventionellen Bildgebung mit unidirektionalem und konstantem Magnetfeldgradienten mit konstanter Stärke $g_0$ ergibt sich die Größe des Aufnahmebereichs FOV im Ortsraum aus der Larmorbeziehung zu

$$FOV = \Delta\omega /(\gamma\, g_0). \qquad (9)$$

$\Delta\omega$ ist dabei die bei der Datenaufnahme verwendete Bandbreite, und bei Aufnahme einzelner (komplexer) Datenpunkte im Abstand $t_s$ ist $\Delta\omega=1/t_s$. Die Ortsauflösung $r_{res}$ (gemessen als Pixelgröße) ist dann gegeben durch

$$r_{res} = FOV/mr = 1/(\gamma\, g_0\, t_s\, mr) = 1/(\gamma\, g_0\, t_{ACQ}) \qquad (10)$$

wobei mr die Zahl der aufgenommenen Datenpunkte (= Matrixgröße) wiedergibt und $t_{ACQ} = t_s$ mr der Akquisitionszeit zur Aufnahme der mr Datenpunkte entspricht.

Bei Verwendung von nichtlinearen SEM sind $\Delta\omega$ und $\omega_{res}$ nach wie vor durch das Nyquist-Theorem gegeben, die räumliche Auflösung $r_{res}(r)$ ist dann jedoch vom Ort abhängig. Bei über $\omega_{res}$ zumindest annähernd linearem Feldverlauf lässt sich die lokale Ortsauflösung $r_{es}(r)$ über die lokale Steilheit $g(r) = d\omega/dr$ des NBSEM am Ort r definieren:

$$r_{res} = \omega_{res}/g(r) = \omega_{res}/(d\omega/dr). \qquad (11)$$

Wie Gl.(9) zeigt, ist die Pixelgröße umgekehrt proportional zur lokalen Steilheit des SEM.

Im Bereich um den Extremwert eines NBSEM ist die Auflösung $r_{res0}$ durch den Bereich definiert, innerhalb dessen die Resonanzfrequenz zwischen $\omega_{min}$ und $\omega_{min} + \omega_{res}$ liegt. Durch Verschiebung des Frequenzrasters um $\omega_{res}/2$ (oder einen anderen Bruchteil von $\omega_{res}$) lässt sich $\omega_{res0}$ entsprechend variieren.

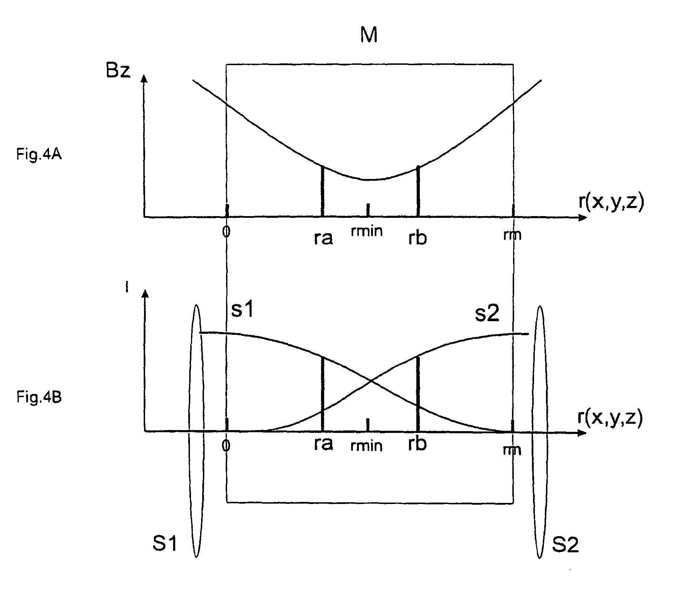

Zur Veranschaulichung der Auflösung der Mehrdeutigkeit der Abbildung in einem solchen NBSEM durch Verwendung von Messspulen mit räumlich unterschiedlicher Sensitivität ist in Fig.4A zunächst wiederum ein solches eindimensionales Feldprofil Bz(r) entlang der Richtung r eines gekrümmten Ortsvektors r(x,y,z) gezeigt, welches wiederum entlang r einen Extremwert aufweist, so dass es beiderseits des Minimums jeweils paarweise Positionen ra und rb gibt, an welchen Bz identische Werte annimmt. Bei einer eindimensionalen Ortskodierung entlang eines solchen Feldprofils sind die Signale der Spins an ra und rb nicht unterscheidbar. Formal lässt sich dies nach dem gesagten dadurch beschreiben, dass Bz innerhalb der Wertebereiche 0...rmin bzw. rmin...rm in zwei Bereiche mit jeweils monotonem Verlauf zerlegt wird. Innerhalb jedes dieser beiden Bereiche werden dann jeweils (eindeutige) lokale Koordinatensysteme r1 und r2 definiert. Für den eindimensionalen Fall ist diese Beschreibung analog zu der von Oppelt, wobei der gekrümmte Ortsvektor r dann in ein uni-dimensionalen Richtungsvektor z (in der Nomenklatur von Oppelt) überführt wird.

Durch entsprechende Verallgemeinerung der Beschreibung von Oppelt für unidirektional alternierende Gradienten lässt sich die mehrdeutige Abbildungsgleichung (1) darstellen als:

$$I_\omega(\omega_{kx}, \omega_{ky}, \omega_{kz}) = I_\omega(\omega_{loc1x}, \omega_{loc1y}, \omega_{loc1z}) + I_\omega(\omega_{loc2x}, \omega_{loc2y}, \omega_{loc2z})... I_\omega(\omega_{locNx}, \omega_{locNy}, \omega_{locNz})$$

$$(5)$$

Eine Unterscheidung der einzelnen Beiträge der gemessenen Signale lässt sich dann dadurch erreichen, dass die Datenaufnahme mit mindestens 2 Empfangsspulen S1 und S2 erfolgt, welche entlang r jeweils unterschiedliche Sensitivitätsprofile s1 und s2 zeigen.

Mit überlappenden Sensitivitätsprofilen (Fig.4B) lassen sich die Signalbeiträge aus r1 und r2 bei bekannten Sensitivitätsprofilen separieren: Die Signale I1 (S1) und I2(S2) setzen sich zusammen als gewichtetes Mittel der Signale I(r1) und I(r2) mit den durch die Sensitivitätsprofile bestimmten Gewichtungsfaktoren s1 und s2:

$$I1(S1) = s1(r1)\ I(r1) + s1(r)\ I(r2)$$

und

$$I2(S2) = s2(r1)\ I(r1) + s2(r2)\ I(r2)$$

Bei bekannten Gewichtungsfaktoren lassen sich aus diesem Gleichungssystem die Signale I(r1) und I(r2) aus den gemessenen Signalen durch Lösung des Gleichungssystems berechnen.

Formal entspricht die Berechnung den Algorithmen von Oppelt, ganz analog zu den bekannten Verfahren, die bei der parallelen Bildgebung eingesetzt werden. Im Unterschied zur parallelen Bildgebung werden diese Prinzipien hier zur Aufhebung der Mehrdeutigkeit der Zuordnung der Resonanzfrequenzen eingesetzt, während herkömmliche Verfahren der parallelen Bildgebung dazu dienen, Mehrdeutigkeiten durch Unterabtastung der für die nachfolgende Bildrekonstruktion eingesetzten diskreten k-Raum-Daten beruhen. Für die Datenrekonstruktion gibt es in der Literatur eine Vielzahl von Algorithmen, welche eine parallele Rekonstruktion entweder auf Basis der direkt aufgenommenen k-Raum Daten vornehmen (SMASH, GRAPPA...) oder anhand der Bilddaten (SENSE...). Eine Übersicht über gängige Techniken findet sich in (Top.in Magnetic Resonance 15, 129 (2004) und Top.in Magnetic Resonance 15, 223 (2004)).

Neben der Verwendung paralleler Bildgebungstechniken zur Reduktion der Menge der aufzunehmenden Daten (und damit der Messzeit) wurden parallel imaging(P1)-Techniken auch zur Reduktion von Artefakten etwa durch Fluss und Bewegung (Magn.Reson.Med 52, 825 (2004)) sowie zur Vermeidung von Einfaltungsartefakten (Top.in Magnetic Resonance 15, 267(2004), J.Magn.Reson. 12, 795 (2004)) sowie zur Verbesserung der Datenaufnahme entlang der Zeitachse (sog. k-t-BLAST-Verfahren (Magn.Reson.Med. 50, 1031 (2003))) verwendet.

3. Apparaturen zur Durchführung des erfindungsgemäßen Verfahrens

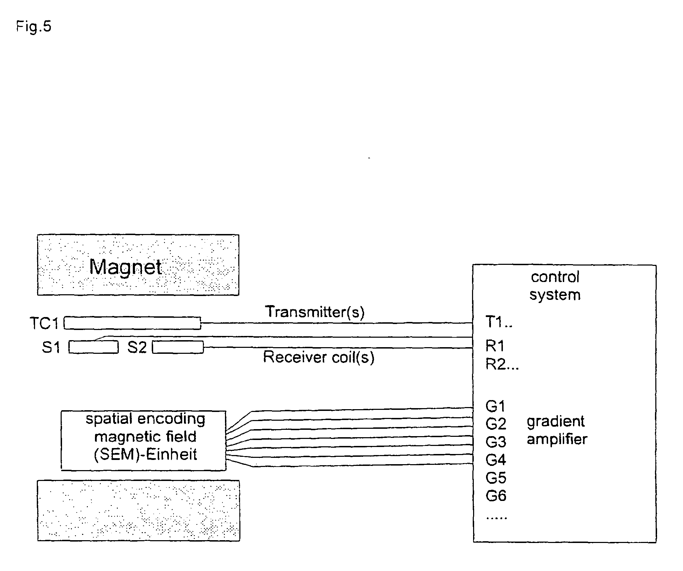

Schematisch lässt sich eine solche Apparatur wie in Fig.5 beispielhaft gezeigt darstellen: Sie besteht aus einem Magnetresonanz-Tomographen bestehend aus einer 'control unit', welche den Messablauf steuert, die zur Anregung verwendeten Hochfrequenzimpulse für die Anregungsspule TC1 über den Senderausgang T1... bereitstellt sowie die von den Empfangsspulen S1, S2... empfangenen Signale an die Empfänger R1, R2... weiterleitet, wobei im Einspulenbetrieb Transmitter- und Empfangsspulen auch identisch sein können. Zur Erzeugung der zur Ortskodierung verwendeten zeitlich und räumlich veränderlichen Magnetfelder dient die SEM-Einheit, welche sich von einem konventionellen Gradientensystem dadurch unterscheidet, dass mindestens eines der hiervon erzeugten SEM als NBSEM ausgebildet ist. Im allgemeinen kann diese SEM-Einheit mehrere und durch G1, G2, G3... gekennzeichnete Partialsysteme enthalten.

Hierbei ist es möglich (und ist in den meisten Fällen auch bevorzugt), dass auch konventionelle x-,y-,z-Gradienten als ortskodierende Felder (SEM) in die SEM-Einheit integriert sind. SEM lassen sich zwar auch anderweitig, wie z.B. durch entsprechende Anordnungen magnetischer Materialien, erzeugen, im allgemeinen und bevorzugt wird jedoch die Felderzeugung durch stromdurchflossene Leiterschleifen bewirkt. Der Begriff der Leiterschleife wird hierbei generisch als stromdurchflossenes Material etwelcher Geometrie verstanden und ist nicht notwendigerweise auf metallische Drähte eines bestimmten Durchmessers beschränkt.

Die Konstruktion und Konfiguration von Leiterschleifen zur Erzeugung von SEM-Feldern eines gewünschten Profils erfolgt dabei nach einem der in der Literatur bekannten Verfahren (s. z.B. Magn.Reson.Med. 34, 604 (1995) und die dort zitieren Arbeiten). Dabei ist darauf hinzuweisen, dass ein bestimmtes SEM nicht notwendigerweise durch eine fest verdrahtete Leiterschleife mit dem Gradientenverstärker erzeugt wird. Vielmehr sind auch Konfigurationen denkbar und u.U. auch vorteilhaft, bei welchen ein bestimmtes SEM durch mehrere unabhängig angesteuerte Leiterschleifen erzeugt wird. Bei konventionellen Gradientensystemen wird bei gleichzeitiger Ansteuerung mehrerer konventioneller Gradienten wiederum ein konstanter Gradient erzeugt, so dass sich durch Kombination mehrerer Gradienten wiederum ein monotoner Gradient in einer durch die Amplitude der einzelnen Gradienten gegebenen Richtung ergibt, d.h. die Form des MSEM bleibt im wesentlichen erhalten, es ändert sich lediglich die Stärke und Richtung. Bei nichtmonotonen SEM hingegen lassen sich je nach Art und Ausprägung durch Variation der Stromstärke und Polarität der Ströme in den jeweiligen Leiterschleifen SEMs unterschiedlicher Geometrie mit ein und derselben Hardwarekonfiguration realisieren.

Beispielhaft lässt sich ein NBSEM entsprechend Fig.2A mit Hilfe von zwei Leiterschleifen G1 und G2 erzeugen. Durch unabhängige Variation der durch G1 und G2 fließenden Ströme kann dann die Lage der die lokalen Feldbereiche trennenden Hyperfläche g0 verschoben werden .

Auch umgekehrt ist es denkbar und u.U. vorteilhaft, mehrere SEMs durch eine gemeinsame Stromversorgung zu speisen, was zu einer optimalen Kohärenz des Feldverhaltens der durch diese SEMs erzeugten Felder führt.

Darüber hinaus lassen sich einzelne oder alle der Partialsysteme der SEM in bekannter Weise als abgeschirmte Gradientensystem, oder zur Kräftekompensation entsprechend Lorentzkraftkompensiert auslegen. Insbesondere dann, wenn ein globales Gradientensystem Teil der SEM-Einheit ist, müssen auch nicht alle Untersysteme alle drei Komponenten zur Raumkodierung enthalten. Die gegenüber dem Stand der Technik notwendige und hinreichende Bedingung besteht darin, dass durch Verwendung mindestens eines NBSEM eine ng(mit ng>=2)-deutige Magnetfeldverteilung erzeugt wird und dass zur eindeutigen Ortskodierung bei der Datenaufnahme mindestens ng Empfangsspulen mit räumlich unterschiedlichem Sensitivitätsprofil verwendet werden.

Aus diesem allgemeinen Prinzip lassen sich eine Reihe von - für die praktische Anwendung bevorzugten und nützlichen - Implementierungen des Verfahrens ableiten, wobei die im folgenden gezeigten Beispiele nicht als vollständige Aufzählung verstanden werden sollen, sondern als Beispiele. Der Fachmann kann ohne weiteres aus den gezeigten Grundprinzipien weitere Implementierungen ableiten.

Ein wesentlicher und bevorzugter Anwendungszweck von PatLoc ist die Realisierung von Ortskodierfeldern mit reduziertem dB/dt bei gleichen Schaltparametern. Erzeugt man eine Feldveränderung gleicher Steigung mit einem bimodalen Gradienten Gpatloc, so ist bei gleicher Steigung (=gleicher Gradientenamplitude) der Extremwert $Bmax_{patloc}$ um etwa einen Faktor 2 geringer, d.h. die Stimulationsschwelle wird daher mit PatLoc-Gradienten im Idealfall erst bei ng-facher Erhöhung der Gradientenstärke oder ng-facher Erhöhung der Schaltgeschwindigkeit $1/\Delta t$ erreicht. Im realen Fall nichtlinearer Gradienten sowie unter Berücksichtigung der Tatsache, dass für reale Systeme x0 außerhalb des linearen Abbildungsbereichs liegt, ergibt sich eine entsprechend weniger ausgeprägte, aber immer noch signifikante mögliche Erhöhung der Schaltgeschwindigkeit. Eine bevorzugte Realisierung eines solchen Patloc-Systems besteht damit darin, dass ein bimodales Feld mit 2 Maxima in der in Fig.6 gezeigten Art erzeugt wird. Hierbei ist darauf hinzuweisen, dass ein solches bimodales NBSEM bei symmetrischer Anordnung bezüglich der Resultierenden der durch Wechselwirkung mit dem Hauptfeld auftretenden Lorentzkräfte in 0.ter Ordnung kraftkompensiert ist und damit auch in Bezug auf Gradientenlärm bzw. mechanische Beanspruchung gegenüber konventionellen Gradienten vorteilhaft ist. Im zentralen Bereich (x=0), in welchem Gpatloc einen horizontalen Verlauf aufweist, ist die Ortsauflösung allerdings entsprechend dem flacheren Feldverlauf entsprechend GI.(9) eingeschränkt, durch entsprechende Wahl von $\Delta\omega$ lässt sich dieser Bereich auch ganz von der Abbildung ausschließen.

Ein weiteres bevorzugtes Anwendungsbeispiel betrifft die Verwendung von flachen Gradienten-Teilsystemen, welche fest mit einer (oder mehreren) Aufnahmespulen verbunden sind. Solche Systeme sind in der Literatur bekannt und beschrieben (Concepts Magn.Reson Part B : 17-29, 2004).

Eine weitere und bevorzugte Realisierung eines PatLoc-Systems ist schematisch in Fig.8A und B gezeigt. Hierbei sind einzelne Teilsysteme so aneinandergefügt, dass die Richtungen x1...xn der jeweiligen Einzelgradienten einen zur Oberfläche der Einzelsysteme orthogonalen Verlauf zeigen. Entsprechend der gezeigten zirkulären Anordnung ergibt sich ein radialer Gradientenverlauf. Solche Systeme sind aber auch in anderen geometrischen Anordnungen realisierbar und eignen sich insbesondere zur Ortskodierung senkrecht zur Oberfläche des untersuchten Körpers. Insbesondere dann, wenn die Geometrie der Anordnung fest vorgegeben wird, erfordert die Realisierung eines solchen Magnetfeldprofils auch nicht notwendigerweise eine Gradientenspule pro Empfangsspule, vielmehr lässt sich eine SEM zur Erzeugung eines entsprechenden Feldverlaufs auch unabhängig von der Empfangsspulenkonfiguration realisieren, wobei die Zahl der Empfangsspulen nach wie vor die Zahl der separierbaren Feldbereiche bestimmt. Mit einer solchen Konfiguration lässt sich ohne weiteres ein zu den Gnx orthogonaler Gradient integrieren, welcher sich entweder als Schichtselektionsgradient senkrecht zur Bildebene oder als Ortskodiergradient einsetzen lässt. Ein solches SEM zu einer solchen 2-dimensionalen Ortskodierung ist vor allem in Kombination mit einer sehr großen Anzahl von Einzelspulen sinnvoll und nützlich, so dass im Extremfall eine durch ortsabhängige Magnetfelder definierte Ortskodierung nur in 2 Richtungen erfolgt, während die Voxelgrösse in der 3.Raumrichtung durch den Empfangsbereich der einzelnen Spulen bestimmt ist (sog. ‚one voxel one coil (OVOC)'-Verfahren).

Wie in Fig 9B gezeigt lassen sich über entsprechende zusätzliche Magnetfelder jedoch auch lokal tangentiale Gradienten zur vollständigen lokalen Ortskodierung erzielen. Gleichpolige Anordnungen (Fig.9A) der einzelnen Felder (++++++++) führen dabei zu einem radialen Feldgradienten. So werden durch alternierende Polarität des Stromflusses in den 8 Gradientenspulen (+-+-+-+-) 8 tangentiale lokal monotone Felder erzeugt. Durch jeweils andere Schemata des Stromflusses in den einzelnen Spulen (++--++--++) lassen sich lokal tangentiale Felder in pseudo-Bessel Anordnung erzeugen.

Hierbei wird an den Orten der lokalen Feldumkehr (also an den durch + und - gezeigten Feldmaxima und Minima) eine Abbildung nur eingeschränkt möglich. Eine kontinuierliche Abbildung lässt sich aber dadurch erreichen, dass entweder durch Rotation des NBSEM um 22,5° oder durch Verwendung eines zweiten um 22,5° rotierten NBSEM eine komplementäre Abbildung erfolgt. Bei durch ein (++--++-++-)-Schema erzeugter 4-poligen Feldanordnung lässt sich die komplementäre, um 45° gedrehte Feldanordnung durch Änderung des Polaritätsschemas nach (+-++--++--+) erzielen. Solche als pseudo-Besselanordnungen bezeichnete NBSEM sind natürlich nicht auf eine 8-fache Symmetrie beschränkt, sondern lassen sich ohne weiteres verallgemeinern. Eine Erhöhung der Zahl der Einzelfelder führt dabei zu einer Verbesserung der Linearität der Tangentialfelder in den jeweils lokalen Feldbereichen, jedoch auf Kosten der Eindringtiefe.

Das Prinzip der Verwendung verschachtelter komplementärer NBSEM-Systeme lässt sich auch auf nicht zirkuläre und nicht periodische NBSEM-Anordnungen dergestalt verallgemeinern (s.Fig.10), dass NBSEM-Systeme miteinander kombiniert werden so, dass jeweils das eine NBSEM am Ort des Minimums des Feldgradienten (=Extremwert des Felds) des anderen NBSEM einen steilen (und womöglich linearen) Feldverlauf aufweist, so dass bei verschachtelter Datenaufnahme jeder Ort des erfassten Messvolumens mindestens von einem der beiden NBSEM-Systeme mit einem für die jeweils angestrebte Ortsauflösung ausreichenden Magnetfeldgradienten ortskodiert wird, so dass sich aus der Gesamtheit der unter Verwendung beider Systeme aufgenommenen Daten eine kontinuierliche Abbildung mit hoher Ortsauflösung auch im Bereich der jeweiligen Hyperflächen erreichen lässt. Auch das in Fig.6 gezeigte bipolare NBSEM mit dem entsprechenden Gsuppl entspricht diesem Prinzip der Komplementarität entsprechend einer (++ --) bzw. (-+ +-) Anordnung.

4. Überblick über die Figuren

Fig.1A Prinzip der Ortskodierung durch Magnetfeldgradienten: Die Datenaufnahme erfolgt im Frequenzraum 1, mit den durch die Feldgradienten Gx, Gy und Gz kodierten Ortsfrequenzen $\omega_{kx}$, $\omega_{ky}$, $\omega_{kz}$. Diese sind mit den Koordinaten x,y und z im Ortsraum $I_r$ in ein-eindeutiger (bijektiver) Weise verknüpft.

Fig.1B Prinzip des erfindungsgemäßen Verfahrens, erster Schritt: die Ortskodierung erfolgt mit nicht-linearen räumlich veränderlichen Magnetfeldern, die so gestaltet sind, dass die Zuordnung von Frequenzraum nach Ortsraum nicht eindeutig ist, sondern vielmehr zumindest eine Teilmenge der ortskodierten Signale einer mindestens zweideutige Abbildung in den Ortsraum unterliegt.

Fig.1C Prinzip des erfindungsgemäßen Verfahrens, zweiter Schritt: Die Datenaufnahme dieser zumindest partiell mehrdeutig kodierten Signale erfolgt mit mindestens zwei Spulen S1 und S2 so, dass sich die jeweils paarweise identisch kodierten Signale über die lokalen Sensitivitäten der beiden Spulen separieren lassen.

Fig.2A Schematische Darstellung einer Realisierung des erfindungsgemäßen Verfahrens (Patloc Typ1). Verwendet wird ein Magnetfeldprofil, welches so ausgestaltet ist, dass es jeweils paarweise Höhenlinien g1(c) und g2(c) beiderseits der durch g0 gezeigten Hyperfläche existieren so, dass das gesamte Magnetfeldprofil durch die Hyperfläche g0 in hier zwei Bereiche Gloc1 und Gloc2 mit jeweils monotonem Feldverlauf geteilt wird. Die Pfeile geben hierbei jeweils die Richtung des lokalen Feldgradienten an zur Verdeutlichung, dass g0 das lokale Feldminimum (oder -maximum) repräsentiert. Entlang der Koordinate r(z) weist der Feldverlauf Bz einen Extremwert auf, das Feldprofil wird durch g0 in zwei lokal monotone Bereiche geteilt. Die Datenaufnahme erfolgt mit 2 Spulen S1 und S2, deren unterschiedliche Empfindlichkeitsprofile eine Separation der jeweils paarweise zweideutigen Signale aus den zwei Feldbereichen erlaubt.

Fig.2B Schematische Darstellung einer Realisierung des erfindungsgemäßen Verfahrens (Patloc Typ2). Verwendet wird ein Magnetfeldprofil, welches so ausgestaltet ist, dass der Feldverlauf eine Krümmung aufweist, so dass er entlang einer Ortskoordinate r(z) einen Extremwert aufweist; das Feldprofil wird durch g0 in zwei lokal monotone Bereiche Gloc1 und Gloc2 geteilt.

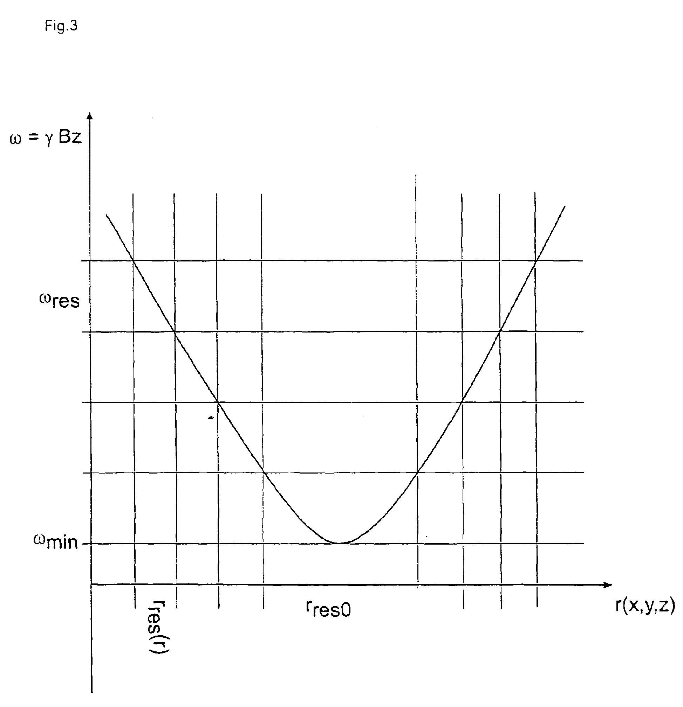

Fig.3 Veranschaulichung der Abbildungseigenschaften in einem nicht-monotonen Magnetfeld: die Auflösung(=Pixelgröße) $\omega_{res}$ im Frequenzraum ist entsprechend dem Sampling Theorem konstant. Durch die Nichtlinearität des Feldverlaufs ergibt sich eine entlang des gekrümmten Ortsvektors r(x,y,z) veränderliche Auflösung $r_{res}(r)$. Im Bereich um das Feldminimum ist die Auflösung $r_{res0}$ durch den Bereich begrenzt, in welchem die Resonanzfrequenz zwischen $\omega_{min}$ und $\omega_{min} + \omega_{res}$ liegt.

Fig.4 Grundprinzip der Verwendung von Empfangsspulen S1 und S2 mit jeweils räumlich variablem Sensitivitätsprofil s1 und s2 zur eindeutigen Zuordnung der durch einen mehrdeutigen (hier parabelförmigen) Verlauf des Magnetfelds B im Abbildungsbereich M. Fig.4A zeigt den Verlauf des Magnetfeldes B entlang einer Ortkoordinate r. ra und rb kennzeichnen zwei Orte identischen Feldes, xmin gibt das Feldminimum an. M kennzeichnet den Messbereich von r=0 bis r= rm. Fig.4B stellt die relative Signalintensität 1 entsprechend der räumlich veränderlichen Sensitivität s1 und s2 der beiden Empfangsspulen S1 und S2 dar und zeigt, dass bei Überlappung der Sensitivitätsbereiche der beiden Spulen die Signale am Ort ra und rb von beiden Spulen mit den jeweiligen Sensitivitäten s1(ra) und s2(ra) bzw. s1 (rb) und s2(rb) detektiert werden.

Fig.5 Schematischer Aufbau einer Messapparatur des erfindungsgemäßen Verfahrens. Die Apparatur verfügt über mindestens eine Senderspule TC1, angeschlossen an mindestens einen als T1..gekennzeichneten (Sender = Transmitter) und mindestens zwei Empfangsspulen S1 und S2, die jeweils an die Empfänger R1 und R2 angeschlossen sind. TC1 kann dabei im Betrieb als Sende-Empfangsspule identisch mit S1 und/oder S2 sein. Die Ortskodierung erfolgt über räumlich veränderliche Magnetfeldeinheiten (Partialsysteme) G1, G2.... und zwar so, dass das Magnetfeldprofil mindestens eines der durch die jeweiligen Einheiten (oder einer Kombination davon) erzeugten Feldprofils nicht-monoton ist, d.h. eine Hyperfläche mit Punkten aus lokalen Feldextrema aufweist und zwar so, dass das Feldprofil durch diese Hyperflächen in ng Teilbereiche mit jeweils monotonem Feldverlauf geteilt wird, wobei ng kleiner oder gleich der Zahl der verwendeten Empfangsspulen ist.

Fig.6 Magnetfeld B als Funktion der Ortskoordinaten x, y in einer bevorzugten Realisierung eines bipolaren NBSEM mit zwei Feldmaxima. Fig.7 zeigt den zugehörigen Konturplot mit den Höhenlinien (=Linien gleicher Resonanzfrequenz) des erzeugten Feldes in der x,y-Ebene.

Fig.8 Anordnung bestehend aus Gradientenspulen (oder Gradienten-Teilsystemen) GS1 bis GS7, welche einen Magnetfeldgradienten in Richtung x1....x7 senkrecht zur jeweiligen Spule erzeugen. Durch Aneinanderreihung solcher Spulen entlang der Oberfläche des zu untersuchenden Objektes wird so eine Ortskodierung senkrecht zur Objektoberfläche erzeugt. Fig.8A zeigt dabei eine konvexe Anordnung, Fig.8B eine Anordnung entlang einer beliebig gekrümmten Fläche.

Fig.9 Oktaedrische Anordnung von 8 Gradientenspulen (oder Gradienten-Teilsystemen) (als schwarze Balken gekennzeichnet). Bei gleichsinniger Ausrichtung der Felder der Einzelspulen (durch ‚+' -Zeichen und den einzelnen Spulen gekennzeichnet) entsteht ein annähernd radialer Magnetfeldgradient orthogonal zu den jeweiligen Einzelspulen (Fig.9A). Bei alternierender Polarität (‚+' bzw. ‚-‚) entstehen im Randbereich acht lokale Bereiche mit annähernd tangentialem Feldgradient (Fig.9B).

Fig.10 Grundschema der komplementären Anordnung von NBSEM-Feldern: Die beiden Felder GA und GB sind relativ zueinander so angeordnet, dass jedes Feld an Stelle der durch lokale Extremwerte gekennzeichneten Hyperflächen (hier durch senkrechte Striche gekennzeichnet) des anderen Feldes einen steilen (und bevorzugt angenähert linearen) Verlauf hat, so dass jeder Ort entlang x im steilen und annähernd linearen Bereich mindestens eines der beiden NBSEM-Felder liegt und damit unter komplementärer Ergänzung der mit GA und GB aufgenommenen Daten eine kontinuierliche Abbildung entlang x erfolgt.

5. Referenzen

‚Magnetic Resonance Imaging', Ed.MT Vlaardingerbroek, Springer-Verlag.1999 ISBN 3-540-64877-1
Top.in Magnetic Resonance 15, 129 (2004)
Top.in Magnetic Resonance 15, 223 (2004)
Top.in Magnetic Resonance 15, 267 (2004)
Magn.Reson.Med 52, 825 (2004)
J.Magn.Reson. 12, 795 (2004)
Magn.Reson.Med. 50, 1031 (2003)
Magn.Reson.Med. 34, 604 (1995)
Concepts Magn.Reson Part B : 17-29, 2004
Oppelt, A, DE 198 43 463 A1
Dennis L. Parker, J. Rock Hadley. Gradient Arrays for High Performance Multiple Region MRI. Proc.14th Meeting ISMRM, Seattle, p.521 (2006).

## EP 1 780 556 B1

### Patentansprüche

**1.** Verfahren der Kernspinresonanztomographie, bei welchem eine, in einem in z-Richtung verlaufenden Hauptmagnetfeld erzeugte, transversale Magnetisierung durch Anwendung von n≥2 zeitlich veränderlichen Magnetfeldern in einem einfach zusammenhängenden abzubildenden Bereich eines Objekts eine n-dimensionale Ortskodierung erfährt,
wobei wenigstens eines der zeitlich veränderlichen Magnetfelder, das als NBSEM bezeichnet wird, gezielt so gewählt wird, dass die Äquipotentiallinien bzw. Äquipotentialflächen der z-Komponente dieses Magnetfelds im abzubildenden Bereich gekrümmt verlaufen, so dass innerhalb des abzubildenden Bereichs entlang einer durch den abzubildenden Bereich verlaufenden Geraden ein lokales Maximum oder Minimum der z-Komponente dieses Magnetfelds auftritt, und wobei eine durch das lokale Maximum bzw. Minimum bedingte Mehrdeutigkeit der Ortskodierung durch die Kombination von mehreren Bilddatensätzen, die mit unterschiedlichem Sensivitätsprofil der RF-Empfangsspuleneinrichtung aufgenommen wurden, beseitigt wird.

**2.** Verfahren nach Anspruch 1, **dadurch gekennzeichnet, dass** das NBSEM in einem Verfahren basierend auf Ortskodierung nach der n-dimensionalen Fouriertransformation eingesetzt wird.

**3.** Verfahren nach einem der Ansprüche 1 oder 2, **dadurch gekennzeichnet, dass** NBSEM Anwendung finden, welche zur Bildrekonstruktion nach einem der Verfahren zur 2- oder 3-dimensionalen Ortskodierung nach dem Verfahren der gefilterten Rückprojektion eingesetzt werden.

**4.** Verfahren nach einem der Ansprüche 1 bis 3, **dadurch gekennzeichnet, dass** zur weiteren Ortskodierung innerhalb des abzubildenden Bereichs mindestens ein weiteres NBSEM angewendet wird, insbesondere wobei die lokalen Feldgradienten aller NBSEM an jedem Ort des abzubildenden Bereichs annähernd senkrecht zueinander ausgebildet sind.

**5.** Verfahren nach einem der Ansprüche 1 bis 4, **dadurch gekennzeichnet, dass** in mindestens einer weiteren Ortsrichtung zur weiteren Ortskodierung in dieser Ortsrichtung im abzubildenden Bereich ein konventioneller Gradient entsprechend einem monoton räumlich veränderlichen Magnetfeld, genannt MSEM - monotonic spacially encoding magnetic field-, angewendet wird, wobei das MSEM in seiner zugehörigen Ortsrichtung im abzubildenden Bereich einen monotonen Feldstärkeverlauf aufweist.

**6.** Verfahren nach einem der Ansprüche 1 bis 5, **dadurch gekennzeichnet, dass** mindestens ein NBSEM zur Ortskodierung einen bimodalen Feldverlauf aufweist, und dass die unter Verwendung dieses bimodalen Feldverlaufs aufgenommenen Teilbilder eine nahezu spiegelbildliche Geometrie aufweisen und entsprechend der unterschiedlichen Sensivitätsprofile der verwendeten Empfangsspulen unterschieden werden.

**7.** Verfahren nach einem der Ansprüche 1 bis 6, **dadurch gekennzeichnet, dass** zur Ortskodierung mindestens zwei NBSEM mit komplementärem Feldverlauf verwendet werden dergestalt, dass im Bereich lokaler Extremwerte des einen NBSEM das andere NBSEM einen steilen und annähernd linearen Feldverlauf aufweist und umgekehrt, und dass die Datenaufnahme mit jedem der beiden komplementären NBSEM in getrennten Aufnahmeschritten erfolgt.

**8.** Verfahren nach einem der Ansprüche 1 bis 7, **dadurch gekennzeichnet, dass** ein NBSEM verwendet wird, dessen zugehöriges Gradientenfeld orthogonal oder annähernd orthogonal zur gekrümmten Oberfläche des Objekts verläuft.

**9.** Verfahren nach einem der Ansprüche 1 bis 8, **dadurch gekennzeichnet, dass** ein NBSEM verwendet wird, dessen zugehöriges Gradientenfeld parallel oder annähernd parallel zur gekrümmten Oberfläche des Objekts verläuft.

### Claims

**1.** Nuclear magnetic resonance tomography method, in which transverse magnetization generated in a main magnetic field extending in the z direction is n-dimensionally locally encoded through application of n≥2 time-varying magnetic fields in a simply connected area of an object to be imaged,
wherein at least one of the time-varying magnetic fields, which is called NBSEM, is specifically selected in such a manner that the equipotential lines or equipotential surfaces of the z component of this magnetic field extend in a curved manner in the area to be imaged such that a local maximum or minimum of the z component of this magnetic

**13**

field occurs within the area to be imaged along a straight line that extends through the area to be imaged, and wherein an ambiguity of local encoding, caused by the local maximum or minimum, is eliminated by the combination of several image data sets which were recorded with a different sensitivity profile of the RF receiver coil device.

2. Method according to claim 1, **characterized in that** the NBSEM is used in a method based on local encoding in accordance with n-dimensional Fourier transformation.

3. Method according to claim 1 or 2, **characterized in that** NBSEMs are applied which are utilized to reconstruct the image in accordance with one of the methods for 2- or 3-dimensional local encoding according to the filtered back projection method.

4. Method according to any one of the claims 1 to 3, **characterized in that** at least one further NBSEM is used for further local encoding within the area to be imaged, in particular wherein the local field gradients of all NBSEMs are approximately perpendicular relative to each other at every location of the area to be imaged.

5. Method according to any one of the claims 1 to 4, **characterized in that** a conventional gradient corresponding to a monotonically spatially varying magnetic field, which is called MSEM (monotonic spatially encoding magnetic field), is applied in at least one further local direction for further local encoding in this local direction in the area to be imaged, wherein the MSEM has a monotonic field strength distribution in its associated local direction in the area to be imaged.

6. Method according to any one of the claims 1 to 5, **characterized in that** at least one NBSEM has a bimodal field distribution for local encoding, and that the partial images acquired using this bimodal field distribution have an almost mirror-symmetrical geometry and are distinguished in correspondence with the different sensitivity profiles of the applied receiver coils.

7. Method according to any one of the claims 1 to 6, **characterized in that** at least two NBSEMs with complementary field distribution are used for local encoding, such that in the region of local extreme values of one NBSEM, the other NBSEM has a steep and approximately linear field distribution, and vice versa, and that the data is acquired with each of the two complementary NBSEMs in separate acquisition steps.

8. Method according to any one of the claims 1 to 7, **characterized in that** an NBSEM is used whose associated gradient field extends orthogonally or approximately orthogonally to the curved surface of the object.

9. Method according to any one of the claims 1 to 8, **characterized in that** an NBSEM is used whose associated gradient field extends parallel or approximately parallel to the curved surface of the object.

**Revendications**

1. Procédé de tomographie par résonance magnétique nucléaire, dans lequel une magnétisation transversale générée dans un champ magnétique principal s'étendant dans une direction z subit un codage local à n dimensions par application de $n \geq 2$ champs magnétiques variables dans le temps dans une zone simplement connexe à représenter, dans lequel au moins un des champs magnétiques variables dans le temps, qui est désigné par NBSEM, est spécifiquement choisi de façon que les lignes équipotentielles ou les surfaces équipotentielles de la composante z de ce champ magnétique aient une distribution courbe dans la zone à représenter, de sorte qu'il apparaît à l'intérieur de la zone à représenter, le long d'une droite s'étendant à travers la zone à représenter, un maximum ou un minimum local de la composante z de ce champ magnétique, et dans lequel une ambiguïté du codage local due au maximum ou au minimum local est éliminée par la combinaison de plusieurs jeux de données d'image qui ont été acquis avec un profil de sensibilité différent du dispositif de bobines de réception RF.

2. Procédé selon la revendication 1, **caractérisé en ce que** le NBSEM est utilisé dans un procédé basé sur le codage local selon la transformation de Fourier à n dimensions.

3. Procédé selon la revendication 1 ou 2, **caractérisé en ce que** l'on utilise des NBSEM qui sont employés pour la reconstitution d'image selon un des procédés pour le codage local à 2 ou 3 dimensions selon le procédé de la rétroprojection filtrée.

4. Procédé selon une des revendications 1 à 3, **caractérisé en ce qu'**au moins un autre NBSEM est utilisé pour un autre codage local à l'intérieur de la zone à représenter, les gradients de champ locaux de tous les NBSEM étant en particulier approximativement perpendiculaires entre eux en tout lieu de la zone à représenter.

5. Procédé selon une des revendications 1 à 4, **caractérisé en ce qu'**un gradient conventionnel correspondant à un champ magnétique variant de façon monotone spatialement, qualifié de MSEM - monotonic spacially encoding magnetic field -, est appliqué dans au moins une autre direction locale pour un autre codage local dans cette direction locale dans la zone à représenter, le MSEM présentant une distribution d'intensité de champ monotone dans sa direction locale associée dans la zone à représenter.

6. Procédé selon une des revendications 1 à 5, **caractérisé en ce qu'**au moins un NBSEM présente une distribution de champ bimodale pour le codage local, et que les images partielles acquises en utilisant cette distribution de champ bimodale présentent une géométrie presque symétrique en miroir et sont distinguées en fonction des profils de sensibilité différents des bobines de réception utilisées.

7. Procédé selon une des revendications 1 à 6, **caractérisé en ce qu'**au moins deux NBSEM ayant une distribution de champ complémentaire sont utilisés pour le codage local, de façon que dans la zone de valeurs locales extrêmes d'un NBSEM, l'autre NBSEM présente une distribution de champ raide et approximativement linéaire, et inversement, et que les données sont acquises avec chacun des deux NBSEM complémentaires dans des étapes d'acquisition séparées.

8. Procédé selon une des revendications 1 à 7, **caractérisé en ce que** l'on utilise un NBSEM dont le champ de gradient associé s'étend orthogonalement ou approximativement orthogonalement à la surface courbe de l'objet.

9. Procédé selon une des revendications 1 à 8, **caractérisé en ce que** l'on utilise un NBSEM dont le champ de gradient associé s'étend parallèlement ou approximativement parallèlement à la surface courbe de l'objet.

Fig.1A

Fig.1B

Fig.1C

Fig.2A

g1(c)

g0

g2(c)

G1

r

Gloc1

Gloc2

x

y

G2

Bz

r(x,y)

g0(r)

Fig.2B

Gloc1

G1

g0

r

Gloc2

G2

Bz

r

g0(r)

Fig.3

Fig.4A

Fig.4B

Fig.5

```
┌─────────────────────────────┐                    ┌──────────────────────┐
│  Magnet                     │                    │  control             │
└─────────────────────────────┘                    │  system              │
                                                    │                      │
TC1 ▭─────────────┐    Transmitter(s)              │  T1..                │
 S1 ▭───▭  S2 ▭───┘    Receiver coil(s)            │  R1                  │
                                                    │  R2...               │
                                                    │                      │
┌─────────────────────────────┐                    │  G1                  │
│  spatial encoding           │                    │  G2   gradient       │
│  magnetic field             │                    │  G3   amplifier      │
│  (SEM)-Einheit              │                    │  G4                  │
└─────────────────────────────┘                    │  G5                  │
                                                    │  G6                  │
┌─────────────────────────────┐                    │  .....               │
│                             │                    └──────────────────────┘
└─────────────────────────────┘
```

Fig.6

Fig. **7**

Fig.8A

Fig.8B

Fig.9A

Fig.9 B

Fig.10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19843463 A1

**In der Beschreibung aufgeführte Nicht-Patentliteratur**

- **Dennis L. Parker ; J. Rock Hadley.** Gradient Arrays for High Performance Multiple Region MRI. *Proc. 14th Meeting ISMRM,* 2006, 521
- *Top.in Magnetic Resonance,* 2004, vol. 15, 129
- *Top.in Magnetic Resonance,* 2004, vol. 15, 223
- *Magn.Reson.Med,* 2004, vol. 52, 825
- *Top.in Magnetic Resonance,* 2004, vol. 15, 267
- *J.Magn.Reson.,* 2004, vol. 12, 795
- *Magn.Reson.Med.,* 2003, vol. 50, 1031
- *Magn.Reson.Med.,* 1995, vol. 34, 604
- *Concepts Magn.Reson Part B,* 2004, 17-29
- Magnetic Resonance Imaging. Springer-Verlag, 1999
- **Dennis L. Parker ; J. Rock Hadley.** Gradient Arrays for High Performance Multiple Region MRI. *Proc.14th Meeting ISMRM,* 2006, 521